# EUROPEAN PATENT APPLICATION

(11) **EP 4 597 616 A1**
(43) Date of publication of application: **06.08.2025**
(21) Application number: 25152052.4
(22) Date of filing: 15.01.2025
(51) Int. Cl.: H01M 4/136, H01M 4/1397, H01M 4/38, H01M 4/58, H01M 10/052

(54) **MONOLITHIC WAFER-LIKE CATHODE SYNERGICALLY GROWN FROM POLY-CRYSTALLINE AND AMORPHOUS GLASS-LIKE DOMAINS AND METHOD OF PRODUCING THEREOF**

(30) Priority: 31.01.2024 LU 103238
(71) Applicant: Theion GmbH, 12487 Berlin (DE)
(72) Inventor: Slavik, Marek, 12487 Berlin (DE); Waidha, Aamir Iqbal, 12487 Berlin (DE)
(74) Representative: Tegethoff, Sebastian

(57) **Abstract**

Disclosed is a method for preparing a chalcogenide/sulfur cathode for an alkali metal secondary battery, where sulfur and/or other chalcogenide and/or mixtures represents both active mass and removable template/ porogen, otherwise defined as glass/amorphous/polymer sulfur wafer where the content of active mass is defined by the glassy sulfur and porosity is dictated by the crystalline phase template, with the steps of growing a chalcogenide/sulfur wafer, comprising tailored content of glass/polymeric and crystalline allotropes, from a mother liquid via a suitable growth process, having a specific presence/gradients/areal distribution of crystalline to glassy/polymeric allotropes, and removing the crystalline allotropes-template/porogen of chalcogenide/sulfur from the chalcogenide/sulfur glass-crystalline wafer by immersing it in a suitable solvent, creating a defined porosity within the wafer by etching crystalline phase out from glass-crystalline wafer-like cathode and leaving 3D glassy/polymeric chalcogenide/sulfur where in a further incubation stage due the meta-stability of glass/polymer allotrope a transition into more preferably gamma monoclinic sulfur with trace amounts of glass/polymer allotropes is created, crosslinked with graphene based and or other suitable co-monomer or co-monomers and or capping agents.

## Description

The present application is directed at a method for preparing a chalcogenide/sulfur cathode for an alkali metal secondary battery, a cathode prepared accordingly, as well as a secondary battery containing the same, according to the features of the independent patent claims.

The past decade has witnessed extensive research in high capacity and high energy density rechargeable alkali-ion and alkali earth-ion chalcogenide-based batteries, preferentially lithium sulfur (Li-S) batteries, in both scientific and industrial communities as a potential next-generation energy storage solution.

The Li-S battery technology promises unparalleled energy density applicable to mobile electronic devices and electric vehicles. Lithium-sulfur (Li-S) battery technology is one of the most promising next-generation energy storage solution due to high specific capacitance of sulfur (1675 mAh g⁻¹), high theoretical volumetric energy density (2800 W L⁻¹) and high gravimetric energy density (2600 Wh kg⁻¹) along with the large availability, low cost and environmental friendliness of sulfur as active material.

However, limited success has been achieved in the commercialization of Li-S batteries mainly originating from the loss of active material during the battery operation, known as lithium polysulfide shuttle (LPS), wherein the long chain lithium polysulfides formed during the initial discharge of LiS battery, dissolve into the electrolyte and shuttle back and forth between the lithium metal anode and sulfur cathode across the separator, and eventually redistribute on the cathode, causing porosity clogging within the conventional slurry-based cathode and also their reaction with Li metal anode, forming a resistive solid electrolyte interface (SEI), leading to a rapid capacity fading and eventually to the dead of the battery.

Exemplary efforts have been dedicated to develop advanced cathodes and addressing the LPSs shuttling but there has not been much improvement in the overall cell performance. Additionally, it is clearly impossible to reach both high gravimetric and volumetric energy densities using state-of-art slurry-based cathode comprising of elemental/orthorhombic sulfur/carbon composite.

Within the traditional LiS batteries, the cathode is prepared via the classical slurry-based process which relies on the principle of particle, aggregates, and clusters (PACs). Within such a concept, the sulfur as an active material is present either in a confined space within the mesoporous/microporous carbon host, or chemically bonded to a host specie like GO, or present as metal disulfide (Fe₂S, Ag₂S etc.). This severely limits the presence of active material within the cathode due to the presence of additional non-active materials like the host, electronic carbon additive and binder.

In addition, within such a slurry-based cathode preparation approach, the resulting porosity occupies high volume percentage, is disordered and random, which leads to high E/S ratio, i.e. electrolyte to sulfur ratio of greater than 5 ml g⁻¹ of sulfur. Thus, significantly limiting both the gravimetric as well as the volumetric energy density achievable from such a LiS battery.

Document US10991944B2 discloses a monoclinic γ-sulfur phase within carbon nanofibers enabling the successful operation of Li-S batteries in carbonate electrolyte for over 4000 cycles. The study discloses an altered redox mechanism of reversibly converting γ-sulfur to Li₂S without the formation of long chain soluble LPSs during the charge/discharge process within the carbonate-based electrolyte. However, the synthesis of the stable γ-sulfur phase in the report involves several hours of synthesis procedure which is time consuming and not scalable. Furthermore, the sulfur loading of less than 2 mg cm⁻² and E/S ratio of 20 was used, thus severely limiting the energy density obtainable from such a cathode. Thus, severely limiting the application of such a cathode for high energy density application. Still, this is a striking discovery and has the potential to overcome some of the classical challenges related to the commercialization of LiS batteries, mainly the LPS shuttle alleviation.

Within the conventional, slurry-based sulfur cathodes, sulfur crystallizes within the thermodynamically stable room temperature allotrope phase, i.e. orthorhombhic sulfur, also referred to as alpha sulfur (α-sulfur) with the density of 2.08 g cm⁻³, which commonly undergoes a two-step reduction reaction mechanism, also known as solid-liquid-solid reaction, with the commonly used ether-based organic electrolyte. On the other hand, using carbonate electrolyte is not suitable due to the nucleophilic attack of the LPS towards the carbonate species, which results in the electrolyte consumption and the end of the battery life. All the other room temperature metastable sulfur allotropes tend to undergo phase/structural transformation to orthorhombic crystalline modification at the room temperature. Via the aging process, the weight fraction of the polymeric/glassy/amorphous to the crystalline content can be tuned/tailored.

Stabilizing the monoclinic (γ), which is the densest form of sulfur (2.18 g cm⁻³) can be achieved by confining sulfur within the micro/meso porous host structures, at temperatures above 155 °C, above which γ-sulfur is known to occur. Once sulfur infiltrates the pores of such a meso-microporous host structures at high temperatures, upon cooling the sulfur is unable to undergo phase transformation from monoclinic γ-sulfur to orthorhombic α-sulfur due to space confinement, i.e. orthorhombic α-sulfur requires higher volume than monoclinic γ-sulfur.

Nevertheless, even if such a monoclinic sulfur is stabilized within a host structure, the cathode from such a sulfur infiltrated host would still need to be produced via the conventional slurry-based approach. Within such a slurry-based cathode the content of active material, i.e. sulfur is usually below 67 wt% of the total content of the cathode mass, hence, significantly reducing the gravimetric energy density. Moreover, the porosity of such cathode is usually around 45 % of the total volume, which is disordered, hence limiting the 100% accessibility of the electrolyte towards sulfur, hence reducing the utilization factor of sulfur along with consuming significant amount of electrolyte to fill the porosity, hence again limiting both the volumetric as well as gravimetric energy density.

Alternative solutions for sulfur cathodes are based on co-polymerized sulfur, for example sulfurized polyacrylonitrile (SPAN) based cathodes, which have shown thousands of stable cycles as a cathode in lithium-sulfur batteries. Although such a cathode limits the formation of the long chain polysulfide species that are soluble in commonly used electrolytes, the overall sulfur content within such co-polymers is usually below 60%, hence implying a low amount of active material and therefore leading to low energy density storage devices.

For the improved performance of LiS batteries, i.e, high sulfur utilization and cycle life along with high energy density, not only the high sulfur loading within the cathode is required but also a desired porosity for volumetric compensation, that occurs during charge/discharge, along with the possibility of limiting the E/S ratio to below 1.5 ml g⁻¹, that can enable high sulfur utilization during battery operation along with both high gravimetric as well as volumetric energy density.

What has recently been proposed by the applicant, and as described for example in document WO 2021233965, the content of which is hereby incorporated by reference, is a unique methodology for creating a self-supported sulfur/chalcogenide positive electrode (cathode) based on direct crystal imprinting/implanting to grow and stabilize the rare monoclinic γ-sulfur for Li-S battery applications, promising superior performance.

The process of direct crystal imprinting/implanting is briefly disclosed also in document EP 3913705 A1, which is hereby also incorporated as reference, as a method for production of a branched and/or hyper-branched monolithic-sulfur-structure cathode body, namely a sulfur wafer, where aligned monoclinic sulfur crystals are grown directly from the sulfur mother liquid, maintained between the temperature range of 95°C to 120°C, where monoclinic β phase is known to be stable and grows with a needle like morphology and result in the formation of sulfur crystal wafer with desired hierarchical porosity induced via the density, population and orientation of seed/nucleation centers within the growing monolithic sulfur wafer.

The methodology as disclosed is not only capable of growing a monoclinic βsulfur in the form of a monolithic crystal wafer, suitable for sulfur-based cathode fabrication, but also capable of stabilizing the unique monoclinic γ sulfur allotrope.

Moreover, the proof of the concept of the technology as disclosed can be further generalized to grow wafer-like structures from other materials, for example Si, Ge, Sn, Ag, and other metals or alloys, etc. and represents a new branch of 3D printing that builds 3D objects at nano/microscale resolutions by controlled nucleation followed by crystallization/solidification (in the case of crystalline/glassy/amorphous materials) and subsequent growth of macro-scale 3D wafer-like objects.

According to the methodology of direct crystal imprinting/implanting, aligned/hierarchically distributed seed carriers serve as the host/substrate possessing defects/host sites. The defects/host sites present on the surface of the seed carriers, i.e. preferentially but not limited to 5 nm in diameter single walled carbon nanotubes, serve as nucleation points for growing nanocrystals, which subsequently form 3D poly-crystalline needle-like structures, having a tailored and hierarchical porosity governed by the presence of aligned seed carriers floating on the surface of growing medium.

The seeds are aligned on top of the mother liquid via an external stimulus, i.e. electric and/or magnetic. These aligned single walled carbon nanotubes further act as an artificial electron percolation and thermal conducting network within the grown wafer, thus lowering the electron tortuosity and enabling high-rate operation of the resulting monolithic sulfur wafer containing LiS battery.

A remaining problem with the method of direct crystal imprinting/implanting as described above is that it is used to grow only the poly-crystalline chalcogenide wafers with a tailored porosity, meaning that porosity is part of the crystal wafer growth process, which makes it difficult to reach a well grown wafer with matched porosity or further modulate the porosity.

It is an object of the present invention, therefore, to overcome the drawbacks as described above and provide a grown sulfur wafer with a possibility of further possibility of tuning the porosity in an easy, economic, environmentally friendly, and cost-effective manner.

This object is solved by the method, cathode and battery with the elements as contained in the independent claims, while preferable embodiments of the invention are described by the elements of the dependent claims.

What is generally provided according to the present invention is a monolithic, self-supporting, positive electrode (cathode), comprising of mixed glass/amorphous /polymeric/crystalline allotropes of sulfur and/or mixtures of other chalcogenide glass/amorphous/polymeric/crystalline allotropes, wherein the cathode is fabricated from the selective growth of a glass/amorphous/polymeric/crystalline chalcogenide/sulfur wafer from a mother liquid, having a tailored presence/gradient of crystalline and glassy/amorphous/polymeric allotropes, wherein during the process crystalline allotropes are removed/etched away by a suitable solvent. Hence, the crystalline sulfur and/or chalcogenides according to the invention represent porogens within the sulfur wafer to create a desired porosity in the sulfur/chalcogenide positive electrode (cathode).

According to the invention, the presence and areal distribution of crystalline allotropes, acting as porogens, within the glass/amorphous/polymeric allotropes defines the cathode porosity wherein the distribution or pattern of glass/amorphous/polymeric allotropes is preferably inserted/transferred onto the surface of the mother liquid by a suitablemethod, preferably by a laser induced, photon or electron radiation patterning or masking.

In article "Laser-induced pattern formation in liquid sulfur - An indication of laser-induced phase transition to ordered polymer" by Y. Sakaguchi & K. Tamura, it has been disclosed that irradiating sulfur and/or other chalcogenides with photons and/or electrons leads to ring-opening-polymerization of sulfur along with the possibility of drawing and/or implanting a predefined pattern on the surface of molten sulfur, thus further helping with tuning the polymeric content versus the crystalline content within the molten sulfur.

From the solubility point of view, polymeric and crystalline phases of sulfur show different behaviour, wherein the crystalline sulfur is known to dissolve in various solvents like CS₂, whereas the polymeric sulfur shows no solubility.

This insoluble sulfur, for example the commercially available material crystex^{™} is a well-known industrial product used in the vulcanization industry.

Based on the difference in the solubility between the polymeric/glass/amorphous and crystalline sulfur, it is possible to use crystalline sulfur as a porogen, i.e. a porosity generating agent being dissolved within a suitable solvent, leaving behind the non-dissolvable glass/amorphous/polymeric allotropes of sulfur, which, according to this invention constitutes the sulfur wafer and will be further processed for its use as cathode within the secondary batteries.

What is achieved with the present invention is that the porosity of the wafer forming the cathode can be tuned and introduced via the dissolution of the crystalline allotropes present in the as grown sulfur wafer. The weight fraction of the glass/amorphous/polymeric sulfur with respect to the crystalline allotropes of sulfur is tuned via irradiation of mother liquid with photons of suitable energy. The as-grown wafer is then subjected to an etching treatment using a suitable solvent, which leads to the dissolution of the crystalline allotrope and/or allotropes of sulfur, leaving behind the glass/amorphous/polymeric sulfur. Hence, the crystalline allotropes of sulfur act as the porogen within the resulting sulfur wafer.

The porosity generation within the as-grown sulfur wafer defined here, i.e. via solvent etching/extraction of crystalline domains, can further be combined with the sulfur wafer grown via the DCi growing method, wherein the porosity is intrinsically part of the growing process. Implying that, depending on the vol% of the porosity within the DCi grown sulfur wafer, further porosity can be generated via the solvent etching of the glass/crystalline phases present within the DCi grown wafer.

The porosity of the as-grown sulfur wafer is preferably a macro porosity with the main aim of reducing the charge carrier tortuosity path for enhanced rate capability, wherein the combined micro/meso porosity generated via the solvent etching of the crystalline phase is responsible for enhanced surface area and redox reaction area.

More specifically, what is provided is a method for preparing a chalcogenide cathode for an alkali metal and alkali earth metal secondary battery, with the steps of growing a chalcogenide wafer comprising glass/amorphous/polymeric and crystalline allotropes of chalcogenide/sulfur from a mother liquid via a suitable growth process, and removing the crystalline allotropes of chalcogenides via dissolution in an appropriate solvent, generating a meta stable wafer with a defined porosity by leaving behind the glass/amorphous/polymeric chalcogenide with possible trace amounts of crystalline allotropes, and incubation of the meta stable wafer in an incubation chamber, preferably at 108°C, to recrystallize the sulfur allotropic core by transitioning it into preferable monoclinic β and/or γ sulfur via the partially entrapped seeds of monoclinic β and/or γ sulfur within the glass/amorphous/polymer shell.

Preferably, preceding removal of the crystalline allotropes, an additional step of adjusting the glass/amorphous/polymeric chalcogenide weight fraction with respect to the crystalline chalcogenide within the wafer to a specific value is provided, wherein more preferably, adjusting the glass/amorphous/polymeric weight fraction comprises irradiating the mother liquid with photons and/or electrons in a predefined duration, intensity, power and/or pattern.

According to another preferred embodiment of the present invention, the step of growing a chalcogenide wafer comprises growing a branched and/or hyper-branched monolithic-sulfur-structure cathode body, namely a sulfur wafer, where needle-like monoclinic β sulfur crystals are grown directly from the sulfur containing mother liquid at a temperature from 95°C to 120°C via the introduction of aligned seeds/nucleation centers and subsequent quenching of the resulting monolithic monoclinic sulfur structure between -8°C to -210°C, preferably below the glass crystalline temperature of sulfur.

The method according to the present invention also comprises the additional step of coating the as grown wafer prepared as described above, with a 2D material like graphene oxide as disclosed in EP23198077.2, in order to form a transparent transition layer that is covalently bound to the sulfur at the graphene oxide/sulfur interface leading to the formation of reduced graphene oxide (rGO), that also impart significant electronic conductivity to the resulting sulfur wafer and enabling the electrochemical/redox activity, wherein graphene oxide coating can be implemented by dip coating, vacuum filtering, spray coating, layer by layer, spin-coating, bar coating, slot-die coating, roll-to-roll printing, screen-printing, flexographic printing, lithographic printing, ink-jet printing or film stretching/coating, vacuum filtering, spray coating, layer by layer, spin-coating, bar coating, slot-die coating, roll-to-roll printing, screen-printing, flexographic printing, lithographic printing, ink-jet printing or film stretching.

The subsequent cross-linking between the graphene oxide and sulfur is achieved by providing a high energy radiation to the transparent graphene oxide layer coated onto the chalcogenide/sulfur wafer and exposing it to high energy photon and/or electron irradiation, wherein the graphene oxide reacts with the sulfur at the graphene oxide/sulfur interface, wherein the higher energy irradiation leads to ring opening of the sulfur, leading to subsequent in-situ de-oxygenation of graphene oxide to reduced graphene oxide and cross linking with the sulfur radicals.

Furthermore, the wafer, in an additional step, can be covered by a second thin layer of 2D material, more preferably electron conducting and permeable to charge carriers within the electrolyte, like MXene, graphene oxide e.t.c .

The second coating layer may be formed by electrophoretic deposition and/or reduction of the second 2D material.

In essence, what is disclosed here is an advanced monolithic, positive electrode , i.e. a cathode for an alkali-ion and/or alkali-earth ion sulfur battery and a battery having the same, and, more particularly, to a lithium-sulfur secondary cathode for a battery exhibiting tailored, hierarchical and/or ordered porosity, originating from the synergistic growth/etching/incubation of glass, amorphous, polymeric and/or crystalline sulfur allotropes with ordered and/or disordered arrangement of sulfur crystalline phases i.e. orthorhombic, monoclinic beta (β) and monoclinic gamma (γ), representing a porogen for the cathode, or other crystalline allotropes having cyclic and/or tadpole structure/lattice on suitable seed carriers together with amorphous glass-like polymeric sulfur allotropes, representing negative resist, which is formed within the crystalline domains, and dissolving at least part of the sulfur crystalline, representing porogen, from the cathode to achieve a non-solube chalcogenide/sulfur cathode with a defined porosity.

The presence, gradient and areal distribution of crystalline allotropes within the glass/amorphous/polymeric sulfur allotropes defines the cathode porosity, wherein the distribution/pattern is inserted/transferred onto the surface of mother liquid by a suitable method, such as adjusting the content of polymeric versus crystalline phases by laser induced patterning or a masking method. Mother liquid is defined herein as molten liquid containing crystalline/cyclic allotropes, solubilized allotropes, wherein the most preferable is a molten glassy/crystalline allotrope containing sulfur and/or other chalcogenides. The mother liquid can also be any solvent with sulfur dissolved in it. The preferable solvent should be capable of dissolving more than 20 weight % of sulfur, like CS₂, ionic liquid or a eutectic solvent like Dowtherm^{™} A, wherein the mother liquid can be subsequently used to grow the sulfur wafer again as mentioned in EP 3913705 A1.

The mother liquid further contains additive like triethanolamine, but not limited to other additives which allow for the preferential growth morphology such as 2D or platelet like growth/orientation of the resulting grown crystals, wherein the amount of the additive is tailored within the range of 0 to 5 wt%.

The result is a self-standing monolithic sulfur wafer cathode comprised of mixed glass/amorphous/polymeric/crystalline allotropes of sulfur and/or mixture of other chalcogenide glass/amorphous/polymeric/crystalline allotropes particularly used as cathode for an alkali-ion sulphur battery capable to provide specific energies ≥700 Wh kg⁻¹ where more preferable ≥1000 Wh kg⁻¹ and cycle life >1000 cycles at 3C rate.

This invention is based on previous direct crystal imprinting/implanting method wherein the main difference is the presence of tailored content of glass/amorphous/polymeric phase within poly-crystalline sulfur, wherein the crystalline allotrope acts as the porogen.

The present invention offers a significant advantage regarding fabrication of a porous sulfur cathode by means of artificially introduced porosity via the tuning of the weight fraction of glass/amorphous/polymeric chalcogenide/sulfur versus crystalline allotropes of sulfur by etching crystalline allotropes from the grown sulfur wafer, using a suitable solvent. By using photon/electron irradiation of the mother liquid, the fraction and presence of glass/amorphous/polymeric sulfur can be tuned minutely by controlling ring opening polymerization of sulfur beyond thermally induced ring opening polymerized sulfur. The resulting as-grown wafer has a hierarchical porosity and along with reasonable flexibility so that subsequent processes on the precursor wafer for its use as cathode may be carried out. In addition, the mass loading of such a cathode is beyond state of the art.

What is also provided is a secondary alkali metal battery comprising a wafer prepared according to the method as described above, wherein the negative/positive ratio at 100% depth of discharge retains residual or ≤ 3% of monoclinic gamma sulfur allotrope crystals whose facets then represent support/lattice match for further epitaxial growth of monoclinic crystals on recharging the battery.

Further characteristics and advantages may be taken from the following description of Figures accompanying this application, showing:
Fig.1: Schematic simplistic illustration of the set up for growing glass crystalline wafer via direct crystal imprinting method;
Fig. 2. A simplistic top view of the laser irradiation on the grown sulfur wafer;
Fig 3. A magnified view a wafer being subjected to laser irradiation;
Fig. 4 A simple schematic illustration of the etching process;

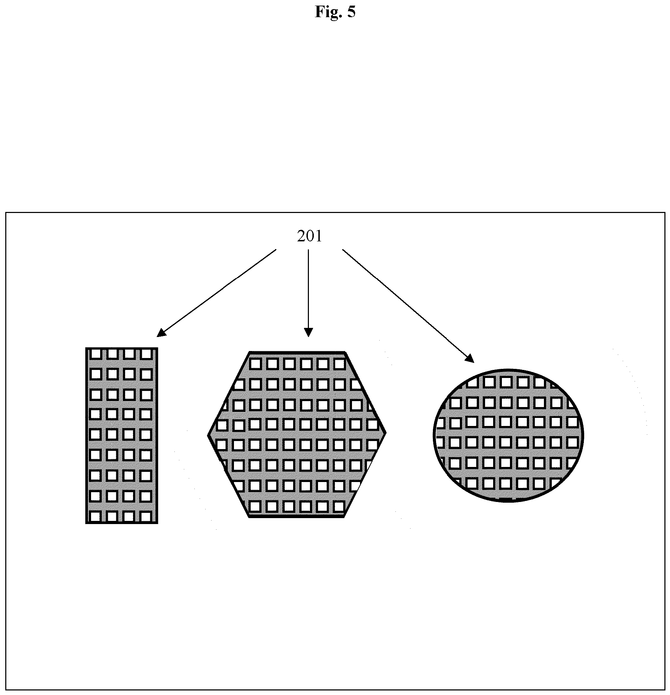

Fig. 5 Different types of glass crystalline wafer architectures possible via the mehod described within this invention.

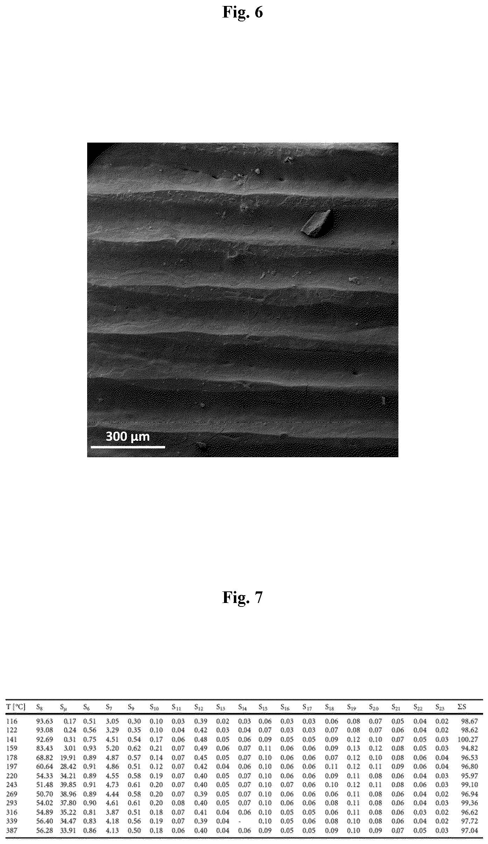

Fig. 6 A SEM micrograph showing a sulfur wafer subjected to the laser irradiation and acting as negative resist, such that the area subjected to irradiation remains and the non-irradiated area is solvent etched.
Fig. 7 a table showing the molecular composition of equilibrated liquid sulfur after quenching the melt at various temperatures as described in 10.1007/b12111.
Fig. 8 a schematic depiction of ratios between glassy and crystalline sulfur at various stages of the method according to the invention

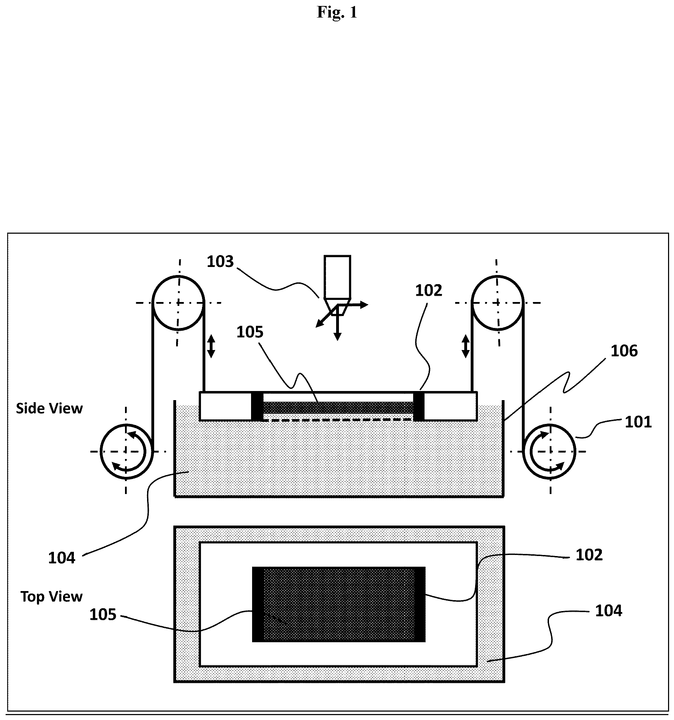

Fig. 1 shows a schematic depiction of the method according to the present invention, wherein in a first step a Dci growth apparatus is adapted to a glass/amorphous/polymeric/ crystalline sulfur wafer, and the surface of the process liquid 104 is being laser patterned with laser 103 to create a tailored presence of glass/amorphous/polymeric versus crystalline domains of sulfur in the growing wafer. 101 shows the simple mechanism for movement of the wafer frame 102 which supports the grown wafer 105, which can be irradiation with the laser source for patterning. The process liquid 104 is contained within a container 106. The top view of the simple arrangement of the set up is also shown.

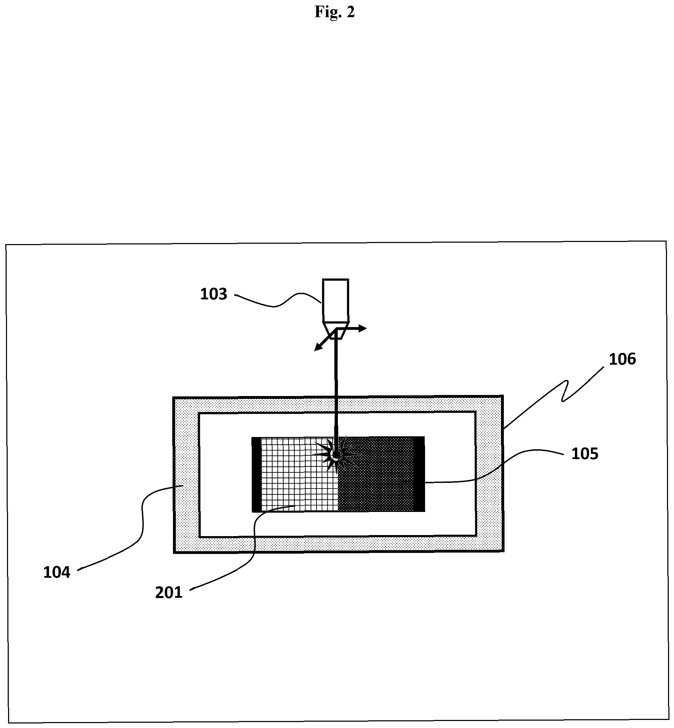

Fig. 2 shows a simplistic top view of the laser irradiation on the grown sulfur wafer, wherein the laser is used to tune the weight fraction of the polymeric/amorphous/glassy sulfur to crystalline sulfur resulting in the glass crystalline wafer 201.

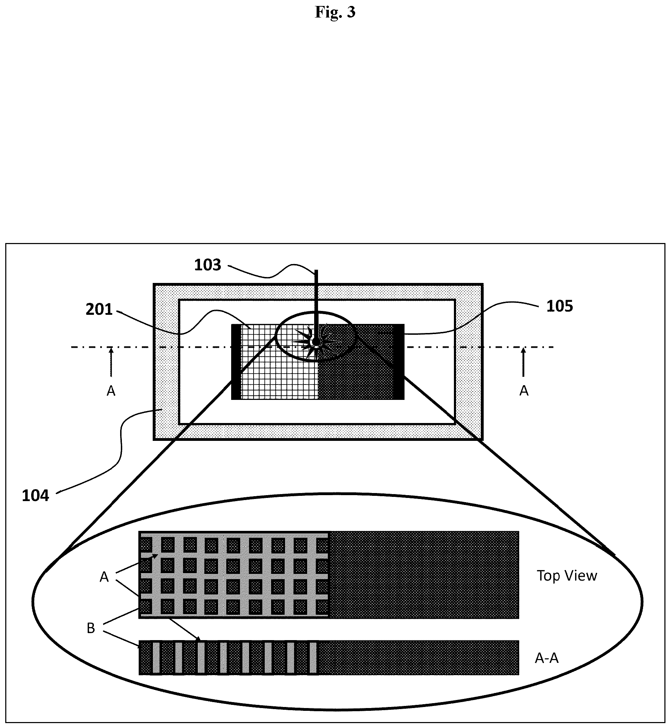

Fig 3. is a magnified view of a wafer being subjected to laser irradiation showing parts which are irradiated (A) and non-irradiated parts (B). The irradiated part consist mainly of the polymeric/amorphous/glassy sulfur, whereas the non-irradiated is the crystalline sulfur that acts as the porogen in the subsequent etching process.

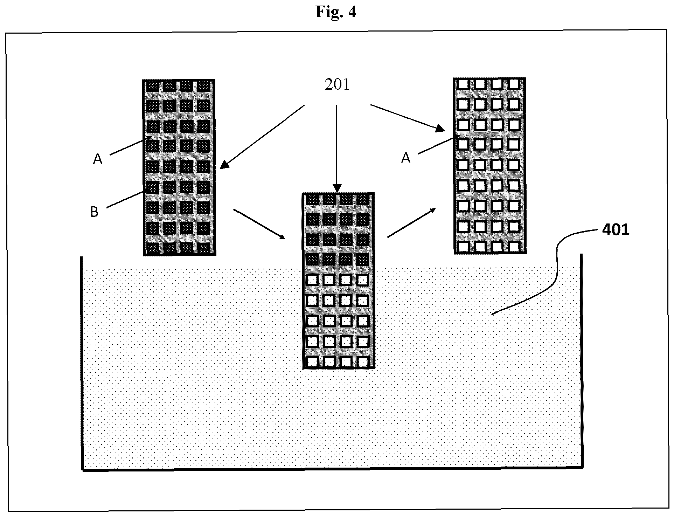

Once the glass/amorphous/polymeric/crystalline sulfur wafer is grown, it is lifted from the surface of the mother liquid and immersed in a suitable solvent, here for example CS₂ or an ionic liquid, etching away the crystalline phase, which acts as a porogen, in the as-grown wafer. Fig. 4 is a simple schematic illustration of the etching process, wherein the glass crystalline wafer is subjected to a treatment in a solvent/etchant 401 capable of dissolving crystalline sulfur, resulting is the retention of the polymeric sulfur and the crystalline sulfur enclosed within the polymeric/amorphous/glassy sulfur that is not accessed by the solvent/etchant.

In the next step the glass/amorphous/polymeric sulfur wafer is coated with a 2D material, like graphene oxide and subjected tophoton/electron irradiation, which leads to ring opening polymerization of sulfur, deoxygenation of graphene oxide to form reduced graphene oxide (rGO) along with cross-link between the two. The details on the process of cross-linking of photon/electron transparent 2D layer and its subsequent cross-linking are described in EP23198077.

The resulting graphene oxide coated electrode, also refered to as "Fish scale coating", is subjected to incubation at the temperature of 108 °C, wherein the glass/amorphous/polymeric sulfur will again recrystallize to the crystalline monoclinic β and/or γ phase. Such a glass/amorphous/polymeric to crystalline transformtion is favourable due to stablity of the monoclinic β and/or γ phase at this temperature and the metastability of the glass/amorphous/polymeric sulfur. The incubation temperature here plays a key role, since a direct transition of glass/amorphous/polymeric sulfur to the crystalline monoclinic phase is desired. It is important to point out, such a graphene oxide coating forms the shell whereas the sulfur undeneath forms the core. Once this step is completed the glass-crystalline sulfur and/or chalcogenide cathode is ready to be used/transfered to the subsequent cathode making process.

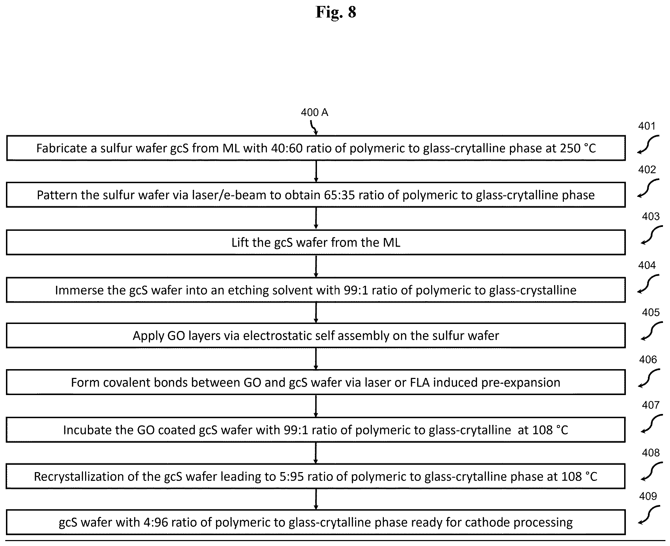

Fig. 8 shows a schematic depiction of ratios between glassy/amorphous/polymeric and crystalline sulfur at various stages and/or steps of the method 400 A according to the invention. As can be seen from Fig. 8, within the conventionally thermally heated sulfur, the maximum ratio between the glassy/amorphous/polymeric and crystalline sulfur can be observed at 243 °C, i.e. 40:60 at step 401.

However, with the use of laser/e-beam pattering of the mother liquid surface, the ratio between glassy/amorphous/polymeric and crystalline sulfur within the sulfur wafer can be adjusted, wherein the weight fraction of glassy/amorphous/polymeric sulfur can be increased upto the value of 65%. The ratio of glass/amorphous/crystalline domains remains preferably at 65:35 till the wafer growth is completed at 402 and the wafer is lifted/removed from the mother liquid at 403. The resulting sulfur wafer, is subjected to immersion in a suitable etching solvent like CS₂ or highly sulfur soluble ionic liquid, whrein the crystalline sulfur is completely removed at 404.

After dissolution/etching of the grown sulfur wafer in the etching solvent and removal of the crystal allotrope/porogen, the resulting cathode comprises mainly glass/amosphous/polymeric domains, such that the weight fraction of crystalline sulfur remains perferbaly below 1 weight% but not limited to and the porosity of the resulting wafer with only residual crystalline sulfur allotropes within the glassy/ amosphous/polymeric allotropes is ≤ 35%.

During the subsequent process of 2D material coating at 405 the ratio of glassy/amorphous/polymeric and crystalline sulfur remains unchanged, i.e. preferably but not limited to 99: 1.

The resulting 2D material coated sulfur wafer is then subjected to laser or flash light annealing in order to lead to cross-linking of sulfur with graphene oxide along with the pre-expansion of sulfur at 406, after which the ratio of glassy/amorphous/polymeric and crystalline sulfur changes, more desirably, but not limited, to 99.5:0.5. Hence, implying that the resulting wafer after such a laser or flash treatment mainly comprises of glassy/amorphous/polymeric sulfur along with the porosity of ≤35 vol%. Herein, the 2D material, more preferably graphene oxide, forms the shell and the sulfur underneath forms the core, wherein the graphene oxide is cross-linked to the sulfur at the graphene oxide /sulfur interface.

In the subsequent fabrication step, the fish-scale coated grown sulfur wafer is transferred to an incubation chamber and maintained at 108 °C for 30 mins at step 407. At step 408 recrystallization of sulfur into monoclinic allotrope, more preferably β and/or γ sulfur within the core of the sulfur wafer takes place, such that phase fraction between the glassy/amorphous/polymeric and crystalline sulfur changes, such that ratio can vary between 10:90, 8:92, 4:96, and more desirably to 5:95, implying that the resulting sulfur wafer now mainly consists of a crystalline sulfur allotrope core and a graphene oxide/reduced graphene oxide coated glassy/amorphous/polymeric allotrope shell.

At the end of the sulfur wafer growth and fabrication process at 409, the resulting glass/polymeric/amorphous/crystalline wafer comprises mostly of crystalline sulfur whrein the ratio between the glassy/amorphous/polymeric and crystalline sulfur can vary between 10:90, 8:92, and, more preferably, 4:96, and the wafer is ready for subsequent cathode making process steps.

The obatained wafer can subseuqently be used for the pre-expansion process as described in patent EP23219761.6. The glass-crystalline wafer is transfered to an ultra-fast pre-expansion apparatus, wherein the temperature of the device can be varied between -110 °C to +4 °C. Next, the glass/crystalline wafer is immersed into process liquid at -110 °C to +4, preferably below the glass transition temperature of sulfur- and exposed to a light source with >15 J/cm² under 500 nm. By means of intense pulse light/flash light annealing, flash heating of the glass-crystalline wafer occurs to a temperature of +365°C/5ms. The excess of process liquid absorbes heat from the photonically pre-expanded wafer, which is quenched and subsequently has a temperature of -8°C. Now the wafer with preferable ratio of 99.5:0.5 glass/crystalline domains is pre-expanded to a density of 1.66 g/cm³ which equals that of Li₂S, whereafter the wafer, now having a ratio of 98:2 glass/crystalline domains, due to the fact that photonically induced expansion is not limited by polymer-crystalline equlibrium known from thermal induced ring opening polymerization so that 98:2 represents possible shielding losses for carbon nanotubes or other additives present inside the cathode, is tranferred to the incubation chamber.

## Claims

1. Method for preparing a chalcogenide/sulfur cathode with tailored porosity for an alkali metal or alkali earth metal secondary battery, with the steps of:
a. growing a chalcogenide/sulfur wafer, comprising glass/amorphous/polymeric and crystalline allotropes, from a mother liquid via a DCI growing method process, having a presence/gradients/areal distribution of crystalline domains and the glassy/amorphous/polymeric allotropes;
b. at least partially removing/etching the crystalline allotropes of chalcogenide/sulfur from the glass/crystalline chalcogenide/sulfur wafer by immersing it in a CS2 solvent, creating a meta stable wafer with a defined porosity with trace amounts of crystalline allotropes, trapped within the chains of glass/amorphous/polymeric chalcogenide/sulfur, and
c. incubation of the meta stable wafer in an incubation chamber to recrystallize the sulfur allotropic core.

2. Method according to claim 1, further comprising the step of tailoring the mass/volume content, areal distribution and gradients of crystalline allotropes within the glassy/amorphous/polymer chalcogenide/sulfur with respect to the glass-crystalline chalcogenide/sulfur, wherein the glass/polymer allotropes stay in the wafer and become active mass in the incubation steps and crystalline allotropes are a removable template/porogen which is then maintained at the specific value via a suitable adjustment/aging process, wherein tailoring the glass/amorphous/polymeric chalcogenide/sulfur weight fraction versus crystalline chalcogenide/sulfur phases comprises irradiating the mother liquid with photons and/or electrons using suitable mask and/or pattern in case of laser/electron beam.

3. Method according to claim 2, wherein irradiating the mother liquid during the growth process of glass/amorphous/polymeric/crystalline wafer-like electrode with photons and/or electrons comprises laser induced patterning and or electron beam patterning.

4. Method according to any of the preceding claims, wherein the process to grow the chalcogenide/sulfur wafer, comprising glass/amorphous/polymeric and crystalline allotropes, from a mother liquid is a direct crystal implanting process (DCi).

5. Method according to any of the preceding claims, further comprising the step of stabilising the wafer with a capping/crosslinking agent.

6. Method according to any of the preceding claims, further comprising the step of subjecting the grown wafer to photon/electron induced pre-expansion to remove/compensate its expansion on electrochemical cycling with suitable charge carriers such as alkali and/or alkali metal earth metal ions.

7. Method according to any of the preceding claims, wherein incubation/aging in the incubation chamber is performed between the glass transition temperature of chalcogenide, more preferably for sulfur up to 112°C.

8. Method according to any of the preceding claims, wherein the step of growing a chalcogenide/sulfur wafer comprises growing a branched and/or hyper-branched monolithic- chalcogenide/sulfur -structure cathode body, namely a chalcogenide/sulfur wafer, where aligned monoclinic chalcogenide/sulfur crystals are grown in synergy with glass/polymeric allotropes and wherein the crystalline allotropes grow directly from floating seed crystals aligned by dielectrophoresis on mother liquid and glass/polymeric allotropes are growing in between the crystalline phases present in a chalcogenide/sulfur containing mother liquid at a temperature from 95°C to 120°C and subsequent quenching of the resulting monolithic monoclinic chalcogenide/sulfur structure between -8°C to -210°C.

9. Method according to claim 8, wherein the step of growing a chalcogenide/sulfur wafer comprises heating the mother liquid between the temperature range of 200 °C and 380 °C, more preferably 243 °C, wherein the insertion of the desired pattern is carried out within this temperature range, changing the weight fraction/ratio between the different allotropes of chalcogenide, more preferably sulfur, followed by quenching to temperature below the glass transition temperature of the chalcogenide, more preferably sulfur.

10. Method according to any of claims 8 or 9, wherein the solvent/eching and/or quenching agent used to quench the glass/amorphous/polymeric/crystalline and remove/etch the crystalline allotropes from the resulting grown wafer is carbon disulfide (CS₂), Dowtherm^{™} or carbamate-based ionic liquids, but limited to such as all suitable chalcogenide solvents/etchants which are maintained/delivered within the temperature range between the solidus and liquidus temperature of the solvent/etchant.

11. Method according to previous claim, wherein the grown wafer is covered with a graphene oxide layer preferably by electrostatic driven self-assembly, dip and or spray coating, wherein after the application, the graphene oxide layers are converted into a reduced graphene oxide transition interface layer which is covalently bound to the sulfur wafer.

12. Method according to claim 11, wherein the step of covering the wafer with a transition layer, comprises providing a high energy radiation to transparent graphene oxide layer coated onto the chalcogenide/sulfur wafer and exposing it to photon/electron radiation of suitable energy, wherein the graphene oxide reacts with the glass/amorphous/polymeric sulfur of the wafer during the irradiation process and leads to ring opening polymerization of sulfur along with the in-situ de-oxygenation/partial reduction of graphene oxide to reduced graphene oxide.

13. Method according to claims 11 or 12, wherein the wafer is covered by a second layer of 2D materials by electrophoretically deposited and reduced graphene oxide decorated or surface charged by suitable metal cations such as but not limited to, such as Fe³⁺, stabilizing the wafer, subsequently reducing Fe³⁺ to Fe⁰ becoming an integral part of the coated layer.

14. Method according to claim 13, wherein the 2D material is a graphene oxide/metal composite.

15. A chalcogenide-based wafer cathode prepared according to any of claims 1 to 14, exhibiting hierarchical and tailored porosity, wherein
a. the hierarchical porosity is the porosity originating from the wafer growing process,
b. the tailored porosity is the result of a post process of extracting/etching of the chalcogenide.

16. The cathode according to claim 15, wherein the distribution of hierarchical porosity accounts for 50-100 % of total porosity volume and the induced/tailored porosity accounts for 0 to 50 % of the total porosity.

17. The cathode according to claims 15 or 16, wherein the tailored porosity is introduced by selective etching/dissolution of crystalline allotropes of chalcogenide, more preferably sulfur from a mixture of glass/amorphous/polymeric/crystalline chalcogenide allotropies.

18. The cathode as described in any of claims 15 to 17, wherein the preferable distribution of hierarchical porosity is 70% of the total porosity volume and the tailored porosity is remaining 30% of the total porosity volume.

19. Cathode for use in an alkali metal battery, comprising a at least one wafer prepared according to any of claims 1 to 14.

20. Secondary alkali metal battery, comprising a cathode according to any of claims 15 to 19.
